# EUROPÄISCHE PATENTSCHRIFT

(11) **EP 1 543 411 B1**
(45) Veröffentlichungstag und Bekanntmachung des Hinweises auf die Patenterteilung: **21.11.2007**
(21) Anmeldenummer: 03808264.0
(22) Anmeldetag: 23.09.2003
(51) Int. Cl.: G06F 9/32, G06F 9/40

(54) **PROZESSOR MIT EXPLIZITER ANGABE ÜBER ZU SICHERNDE INFORMATIONEN BEI UNTERPROGRAMMSPRÜNGEN**
PROCESSOR WITH EXPLICIT INFORMATION ON INFORMATION TO BE SECURED IN SUB-PROGRAM BRANCHES
PROCESSEUR COMPRENANT DES DONNEES EXPLICITES SUR LES INFORMATIONS A SAUVEGARDER EN CAS DE BRANCHEMENTS VERS UN SOUS-PROGRAMME

(30) Priorität: 27.09.2002 DE 10245367
(43) Veröffentlichungstag der Anmeldung: 22.06.2005
(73) Patentinhaber: Infineon Technologies, 81669 München (DE)
(72) Erfinder: DIRSCHERL, Gerd, 81549 München (DE); GAMMEL, Berndt, 85570 Markt-Schwaben (DE); SMOLA, Michael, 80636 München (DE)
(74) Vertreter: Schoppe, Fritz
(86) Internationale Anmeldenummer: PCT/EP2003/010597
(87) Internationale Veröffentlichungsnummer: WO 2004/042559

(56) Entgegenhaltungen:
- EP-A- 1 192 538
- GB-A- 2 007 891
- US-A- 5 325 494
- DAVIDSON J W ; WHALLEY D B: "Methods for saving and restoring register values across function calls" SOFTWARE -PRACTICE AND EXPERIENCE, Bd. 21, Nr. 2, Februar 1991 (1991-02), Seiten 149-165, XP008036353 UK
- COHEN P E: "An abundance of registers" SIGPLAN NOTICESS, Bd. 23, Nr. 6, Juni 1988 (1988-06), Seiten 24-34, XP008036341 US

## Beschreibung

Die vorliegende Erfindung bezieht sich auf Prozessoren im allgemeinen und insbesondere auf die Verwaltung von Zwischenergebnissen bei Sprüngen in ein Unterprogramm.

Der Betriebsablauf von Prozessoren wird durch Programme gesteuert, die aus mehreren Befehlen bestehen. Im einfachsten Fall arbeitet der Prozessor das Programm vom Anfang bis zum Ende linear gemäß einer vorbestimmten Abarbeitungsreihenfolge ab ohne dabei Programmteile mehrmals zu durchlaufen. Das Programm ist hierzu linear im physikalischen Speicher oder, in dem Fall einer virtuellen Speicheradressierung, im virtuellen Adreßraum abgelegt bzw. angeordnet.

Zur Vermeidung der wiederholten Speicherung identischer Programmteile mit einer identischen Folge von Befehlen weisen Programme jedoch zumeist sogenannte Unterprogrammsprungbefehle (CALLs) auf, bei deren Auftreten die Abarbeitung in einem Teil des Programms, einem sog. Unterprogramm, fortgesetzt wird, bis ein Rücksprungbefehl (Return) in dem Unterprogramm auftritt, woraufhin die Abarbeitung des Programms an der Stelle fortgesetzt wird, die gemäß der Abarbeitungsreihenfolge auf den Unterprogrammsprungbefehl folgt. Auf diese Weise reduziert sich der zur Speicherung des Programms benötigte Speicher auf den zur Speicherung der Befehle des Unterprogramms sowie der Sprungbefehle benötigten im Vergleich zu dem Speicher, der notwendig wäre, um bei jedem Mal das vollständige Unterprogramm zu speichern.

Während der Abarbeitung des Programms erzeugt der Prozessor Zwischenergebnisse, die er in interne Register des Prozessors schreibt. Diese internen Register sind einerseits schneller beschreibbar bzw. lesbar als der dem Prozessor zur Verfügung stehende externe Speicher, wie z.B. ein RAM oder ein EEPROM, ist aber andererseits in seiner Speicherkapazität sehr begrenzt, da er teuer ist. Um während der Abarbeitung des Unterprogramms wirklich einen vollständigen Zugriff auf den schnellen internen Speicher des Prozessors zuzulassen, muß bei Programmierung des Programms sichergestellt werden, daß diejenigen Zwischenergebnisse in den internen Registern, die in dem Mutter- bzw. Hauptprogramm nach Ausführung des Unterprogramms noch benötigt werden, nicht durch Überschreiben dieser internen Register während der Ausführung des Unterprogramms verlorengehen.

Eine erste und zugleich einfachste Möglichkeit, Zwischenergebnisse in den internen Registern während der Dauer eines Unterprogramms zu sichern, besteht darin, in den Programmcode in Abarbeitungsreihenfolge vor dem entsprechenden Programmverzweigungsbefehl bzw. dem Sprungbefehl Speicherbefehle vorzusehen, die die Registerinhalte der Reihe nach, Register um Register, in einen vor Überschreiben sicheren Speicherort zu speichern, wie z.B. in einen externen RAM. Ein Beispiel eines solchen Speicherbefehls ist beispielsweise der Befehl MOV <Speicherortadresse>, Rx, wobei die übliche Notation für die Schreibweise von Befehlen von Befehlen verwendet wird und der Operand <Speicherortadresse> die Adresse des Speicherorts angibt, in welchem der Registerinhalt des Registers Rx gespeichert werden soll. Nachteilig an dieser Vorgehensweise ist, daß pro zu sicherndem Zwischenergebnis bzw. pro Register, dessen Inhalt gesichert werden soll, ein oder, je nach Datenorganisation, sogar mehrere Befehle notwendig sind, so daß sich die Länge des Programmcodes und, genauer, der Aufwand an Codespeicher pro Programmverzweigung enorm erhöht.

Eine verbesserte Möglichkeit zur Sicherung von Registerinhalten für die Dauer eines Unterprogramms besteht darin, zur Vorabspeicherung der zu sichernden Registerinhalte spezialisierte Befehle zu verwenden, die die zu sichernden Registerinhalte nicht einzeln, sondern gruppenweise oder auf einmal in einem hierzu vorgesehenen Sicherungsspeicher ablegen. Ein Beispiel für einen solchen Speicherbefehl ist beispielsweise eine Multiple-Push-Operation bzw. Mehrfachbefüllungsoperation, wie z.B., in üblicher Notation geschrieben, Push <Rx, Ry, Rz ...>, wodurch die Registerinhalte der Register Rx, Ry, Rz ... in einen hierfür vorgesehenen Stapelspeicher eingegeben werden. Obwohl sich der Aufwand an Befehlszeilen in dem Programmcode durch die Zusammenfassung mehrerer Speicherbefehle zu einem einzigen Speicherbefehl verringert, sind dennoch zumindest zwei Befehlszeilen zur Vorbereitung der Abarbeitung des Unterprogramms notwendig, nämlich der Mehrfachspeicherbefehl und der Programmverzweigungsbefehl.

Eine letzte Möglichkeit der Sicherung von Registerinhalten für die Dauer eines Unterprogramms besteht in einer automatischen Erkennung der zu sichernden Daten bzw. Registerinhalte durch Protokollierung derjeniger Register, welche in Vorfeld des Sprungbefehls mit Zwischenergebnissen beschrieben worden sind. Die Registerinhalte der entsprechend erkannten internen Register werden gemäß dieser Möglichkeit bei Auftreten eines Verzweigungsbefehls automatisch "zu den zu konservierenden Daten" gerechnet, d.h. zu einem Stapelspeicher oder einem sonstigen Sicherungsspeicher, der nicht so sehr den größenmäßigen Beschränkungen der internen Register ausgesetzt ist, gesichert. Obwohl bei der letztgenannten Möglichkeit der Datensicherung lediglich eine Befehlszeile bzw. ein Verzweigungsbefehl in demjenigen Teil des Programms, von dem der Sprung in das Unterprogramm aus durchgeführt wird und der im folgenden als Mutterprogramm bezeichnet wird, notwendig ist, besteht ein Nachteil darin, daß bei der automatischen Erkennung nicht berücksichtigt werden kann, welche der während der Abarbeitung des Mutterprogramms in die jeweiligen internen Register gespeicherten Daten nach der Abarbeitung des Unterprogramms zur Verfügung stehen müssen und welche nicht, so daß der zur Sicherung dieser Daten dienende Sicherungsspeicher vergeudet wird bzw. ein größerer Sicherungsspeicher notwendig ist als unbedingt notwendig wäre.

Wie bereits erwähnt, korrespondiert mit dem Sprungbefehl in dem Mutterprogramm ein Rücksprungbefehl im Unterprogramm, bei dessen Auftreten die Abarbeitung an dem auf den Unterprogrammsprungbefehl in dem Mutterprogramm folgenden Befehl fortgeführt wird. An dieser Stelle sind entsprechend zu den Befehlen der Vorabdatensicherung beim Sprungbefehl Befehle zur Wiederherstellung bzw. Restaurierung der zur weiteren Abarbeitung des Mutterprogramms notwendigen Daten erforderlich.

Eine zu der vorgehend zuerst beschriebenen Möglichkeit korrespondierende Möglichkeit zur Datenrestaurierung besteht in einfachen Ladebefehlen, wie z.B. MOV Rx, <Sicherungsortadresse>, die zu den Speicherbefehlen äquivalent sind. Eine der zweiten Möglichkeit entsprechende Variante verwendet beispielsweise einen Mehrfach-Pop-Befehl bzw. Mehrfach-Abgabe-Befehl, wie z.B. Pop <Rx, Ry, Rz ...>, woraufhin eine der Anzahl von Registern Rx, Ry, Rz ... entsprechende Anzahl von Registerinhalten aus dem Stapelspeicher entnommen und in diese Register eingetragen wird. Im Fall der Verwendung der letztgenannten Möglichkeit zur Datensicherung vor Sprungbefehlen werden die zur restaurierenden Registerinhalte automatisch bei Auftreten des Rücksprungbefehls (wie z.B. RET) wiederhergestellt bzw. in die jeweiligen internen Register geschrieben, wobei die Informationen, welche der Register automatisch gesichert worden sind und, anders ausgedrückt, wie viele Registerinhalte dem Sicherungsspeicher entnommen werden sollen, und in welche Register dieselben geschrieben werden sollen, bereits bei Ausführung des "automatischen Sprungbefehls" zusammen mit den zu sichernden Registerinhalten in den Sicherungsspeicher gespeichert werden.

Die vorhergehende Erörterung bezüglich des Rücksprungs vom Mutterprogramm in das Unterprogramm hat verdeutlicht, daß das Problem des Aufwands an Befehlszeilen zur Sicherung zu restaurierender Daten in den Registern noch einmal nach Abarbeitung des Unterprogramms auftritt, wodurch sich der Aufwand an Befehlszeilen insgesamt verdoppelt.

Obwohl das Problem des Mehraufwands an Befehlszeilen beim Aufruf von Unterprogrammen angesichts der rasanten Entwicklung in den Speichertechnologien bei den meisten Anwendungen, wie z.B. bei Personalcomputeranwendungen, lediglich ein geringfügiges Problem darstellt, gibt es speicherrestriktive Anwendungsgebiete, bei denen der Programmspeicher zur Speicherung des Programmcodes in mehrfacher Hinsicht äußerst begrenzt ist. Ein Beispiel eines solchen Anwendungsgebiets sind Chipkarten, wie sie beispielsweise im bargeldlosen Zahlungsverkehr eingesetzt werden. Industrienormen geben die zur Verfügung stehende Chipfläche vor, was wiederum die zur Verfügung stehende Speicherkapazität begrenzt. Erhöht wird das Problem durch die hohen Sicherheitsanforderungen, welche äußerst aufwendige und damit großflächige Kryptocoprozessoren zur Berechnung der äußerst rechenintensiven Kryptoalgorithmen notwendig machen. Zudem wird an Chipkarten ein hohes Maß an Benutzerfreundlichkeit gestellt, zu dem auch eine möglichst kurze Terminalzeitdauer gehört. Um schnelle Terminalzeitdauern zu ermöglichen, müssen kryptographische Berechnungen parallelisiert werden, was einen Kompromiß zwischen erforderlicher Chipfläche, erforderlicher Rechenzeitdauer der Kryptocoprozessoren und zugrundeliegender Schlüssellängen erforderlich macht. Zudem sehen manche Chipkartenanwendungen eine Übertragung von Programmcodes vor, nämlich von Terminal zu Chipkarte, so daß auch hier aufgrund der begrenzten Übertragungsrate bzw. -geschwindigkeit eine reduzierte Programmcodelänge für kürzere Terminalzeitdauern wünschenswert sind. Letzteres gilt entsprechend freilich auch für andere Anwendungsgebiete, wie z.B. bei der Übertragung von Programmcodes an Satelliten oder dergleichen.

In Davidson J.W. et al.: "Methods for saving and restoring register values across function calls" Software Practice and Experience, Bd. 21, Nr. 2, Februar 1991 (1991-02), Seiten 149-165, wird eine Möglichkeit zur Speicherung und Wiederherstellung von Registerinhalten über Funktionsaufrufe hinweg beschrieben. Dabei wird die Verwendung von Masken beschrieben, die Register anzeigen, die in einer Funktion verwendet worden sind. Alternative Vorgehensweisen zur Kennzeichnung der zu sichernden Informationen werden in Form von entweder eigens vorgesehenen Zusatzbefehlen oder den allgemeinen Speicherbefehlen beschrieben.

Der vorliegenden Erfindung liegt die Aufgabe zugrunde, ein Konzept zur Datensicherung bei Unterprogrammsprungbefehlen zu schaffen, das effizienter ist.

Diese Aufgabe wird durch einen Prozessor gemäß Anspruch 1, ein Verfahren gemäß Anspruch 19 und ein Computerprogramm gemäß Anspruch 20 gelöst.

Der vorliegenden Erfindung liegt die Erkenntnis zugrunde, daß eine sowohl zeitunaufwendigere als auch speicherunaufwendigere Behandlung von Unterprogrammsprüngen erzielt werden kann, indem in den Unterprogrammsprungbefehl als Operanden nicht nur die Zieladresse sondern auch Sicherungsinformationen darüber integriert werden, welche Daten nach der Abarbeitung des Unterprogramms im Mutterprogramm noch benötigt werden. Getrennte Befehle im Programm, einmal zur Sicherung der zu sichernden Daten und das andere Mal für den eigentlichen Sprung ins Unterprogramm, sind nicht erforderlich, wodurch sowohl die Abarbeitungszeitdauer des Programms als auch die Programmlänge reduziert werden können. Zudem kann der Compiler bzw. Programmierer, anders als bei den in der Beschreibungseinleitung beschriebenen "automatischen Sprungbefehlen", gezielt Einfluß auf die Auswahl der zu sichernden Daten bzw. der Speicherplätze, deren Inhalte gesichert werden sollen, Einfluß nehmen, so daß der benötigte Speicher zur Sicherung der zu sichernden Daten nur mit denjenigen Daten "belastet" werden muß, die nach der Abarbeitung des Unterprogramms im Mutterprogramm unbedingt benötigt werden.

Bevorzugte Ausführungsbeispiele der vorliegenden Erfindung werden nachfolgend bezugnehmend auf die beiliegenden Zeichnungen näher erläutert. Es zeigen:
- Fig. 1: ein Blockschaltdiagramm des Prozessors und seiner Umgebung gemäß einem Ausführungsbeispiel der vorliegenden Erfindung;
- Fig. 2: einen schematischen Aufbau eines Unterprogrammsprungbefehls gemäß einem Ausführungsbeispiel der vorliegenden Erfindung;
- Fig. 3: eine schematische Zeichnung, die ein Ausführungsbeispiel eines Programms aus Mutterprogramm und Unterprogramm darstellt;
- Fig. 4a: bis 4d schematische Darstellungen des Inhalts interner Register und eines Sicherungsstapelspeichers während aufeinanderfolgender Situationen bei der Abarbeitung des Programms von Fig. 3 gemäß einem Ausführungsbeispiel der vorliegenden Erfindung;
- Fig. 5: ein Flußdiagramm eines Unterprogrammsprungbefehlzyklus gemäß einem Ausführungsbeispiel der vorliegenden Erfindung;
- Fig. 6: eine schematische Zeichnung, die ein sich in drei Hierarchieebenen aufteilendes Programm darstellt; und
- Fig. 7: ein schematisches Diagramm, das die Inhalte interner Register und eines Sicherungsstapelspeichers nach einem Unterprogrammsprungbefehl von dem Unterprogramm höherer Ebene zu dem Unterprogramm niedrigerer Ebene veranschaulicht.

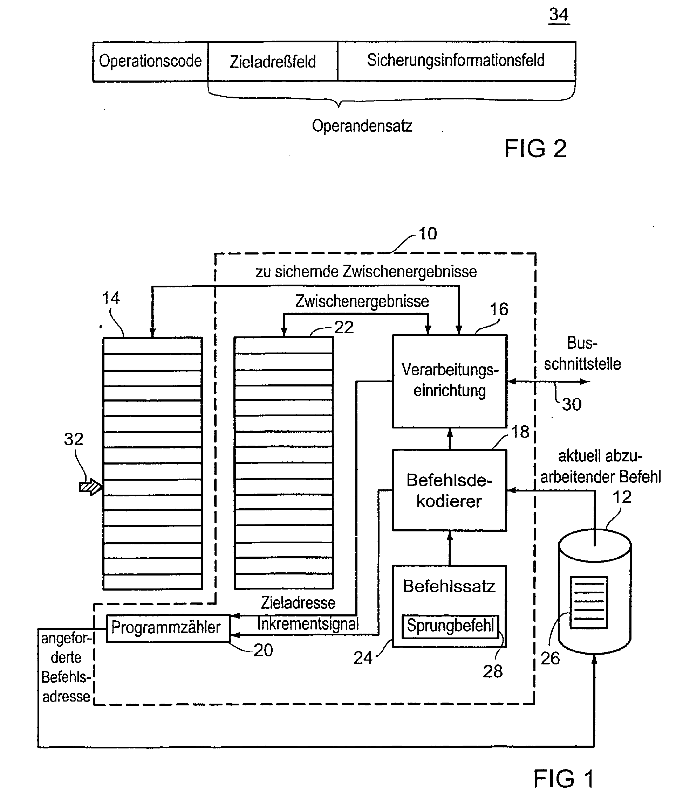

Fig. 1 zeigt ein Ausführungsbeispiel eines Prozessors und seiner Umgebung gemäß einem Ausführungsbeispiel der vorliegenden Erfindung, bei welchem das erfindungsgemäße Konzept zur Datensicherung bei Unterprogrammsprüngen implementiert werden kann. Vorsorglich wird darauf hingewiesen, daß das Ausführungsbeispiel von Fig. 1 lediglich exemplarischer Natur ist und zur besseren Verständlichkeit dienen soll. Obwohl folglich bei dem Ausführungsbeispiel von Fig. 1 lediglich die Behandlung von physikalischen Adressen vorgesehen ist, kann die vorliegende Erfindung gleichermaßen im Rahmen einer virtuellen Speicheradressierung verwendet werden.

Fig. 1 zeigt einen Prozessor 10 mit einem Programmspeicher 12, wie z.B. einem EEPROM oder einem ROM, und einem Stapelspeicher 14. Der Prozessor 10 umfaßt eine Befehlsverarbeitungseinrichtung 16, einen Befehlsdecodierer 18, einen Programmzähler 20 und einen Satz von internen Registern 22. Der Prozessor 10 umfaßt ferner einen Befehlssatz 24. Der Befehlsdecodierer 18 ist mit dem Programmspeicher 12 verbunden, um von demselben den jeweils aktuell abzuarbeitenden Befehl unter den Befehlen des abzuarbeitenden Programms 26 zu erhalten, das in dem Programmspeicher 12 gespeichert ist.

Der Befehlsdecodierer 18 verfügt ferner über Kenntnis des Befehlssatzes 24. Der Befehlssatz 24 umfaßt alle möglichen Befehlstypen bzw. Befehlsoperationen, zu deren Ausführung der Prozessor 10 fähig ist. Jeder Befehl des Programms 26 und somit auch der aktuell abzuarbeitende Befehl entsprechen einer der Befehlsoperationen des Befehlssatzes 24 und unterscheidet sich von dieser lediglich durch die bestimmten Werte seiner Operanden, die bei der Befehlsoperation nur der Anzahl, der Größe und dem Zweck nach bestimmt sind. Zur eindeutigen Unterscheidbarkeit der Befehle bzw. Befehlsoperationen ist jedem Befehl bzw. jeder Befehlsoperation ein eindeutiger Operationscode zugewiesen, anhand dessen der Befehlsdecodierer 18 jeden eingehenden abzuarbeitenden Befehl nach seinem Befehlstyp bzw. Befehlsoperation unterscheiden kann. Jeder Befehlsoperation können unterschiedliche viele Operanden zugewiesen sein, die zur Ausführung der Befehlsoperation notwendig sind. Der Befehlsdecodierer 18, der aufgrund des Operationscodes auf den Befehlstyp des eingehenden Befehls rückschließen kann, kennt somit auch die Anzahl der Operanden, die zu dem jeweils eingehenden Befehl gehören. Der Befehlsdecodierer 18 fordert somit nach Eingang des Operationscodes des aktuell abzuarbeitenden Befehls so viele Operanden des Befehls aus dem Speicher 12 an, wie zu dem aktuell abzuarbeitenden Befehl aufgrund seines Befehlstyps gehören, woraufhin das Auslesen des aktuellen Befehls abgeschlossen ist. Unter anderem umfaßt der Befehlssatz 24 eine Unterprogrammsprungbefehloperation 28, auf die im folgenden noch näher eingegangen wird.

Der Befehlsdecodierer 18 ist ferner mit der Befehlsverarbeitungseinrichtung 16 verbunden, um derselben den Befehlstyp des aktuell abzuarbeitenden Befehls sowie die zur Verarbeitung desselben notwendigen Operanden desselben mitzuteilen.

Der Befehlsdecodierer 18 ist ferner mit dem Programmzähler 20 verbunden, um auf den Erhalt des aktuell abzuarbeitenden Befehls hin ein Inkrementsignal an den Programmzähler 20 zu senden. Der Programmzähler 20 enthält einen Wert, der stets an die Stelle des Programms 26 zeigt bzw. stets an die Adresse desjenigen Befehls in dem Programm 26 zeigt, welcher als nächster gemäß der Abarbeitungsreihenfolge abgearbeitet werden soll. Da die Befehle aufgrund ihres unterschiedlichen Aufbaus, d.h. ohne oder mit Operand bzw. Operanden, verschiedene Längen aufweisen und somit verschieden viele Adreßpositionen in dem Programm 26 einnehmen, teilt das Inkrementsignal dem Programmzähler 20 die notwendige Anzahl von Adreßinkrementierungen mit, um auf den nächsten Befehl in dem Programm 26 zu zeigen.

Die Verarbeitungseinrichtung 16 verarbeitet die Befehle je nach Befehlstyp und, falls vorhanden, unter Zuhilfenahme der Operanden. Während der Programmabarbeitung schreibt die Verarbeitungseinrichtung 16 unter anderem Prozessorzwischenergebnisse bzw. Daten in ein Mehrfachregister 22, welches bei dem vorliegenden Beispiel exemplarisch aus 16 Registern besteht. Der Befehlsverarbeitungseinrichtung 16 steht auch eine Busschnittstelle 30 zu einem Bus (nicht gezeigt) zur Verfügung, über die die Befehlsverarbeitungseinrichtung 16 gesteuert durch die Befehle des Programms 26 mit Peripherieeinheiten kommunizieren kann, wie z.B., in dem Fall einer Chipkarte, mit einem Kryptocoprozessor, einer Terminalschnittstelle oder dergleichen.

Die Befehlsverarbeitungseinrichtung 16 ist zudem zur Sicherung der Daten in dem Register 22 während der Dauer der Abarbeitung eines Unterprogramms, wie es im folgenden näher erläutert werden wird, mit dem Sicherungsstapelspeicher 14 verbunden, um diejenigen Daten, die nach der Abarbeitung des Unterprogramms zur Verfügung stehen sollen, in denselben einzutragen (Push), wobei ein Sicherungsstapelspeicherzeiger, der in Fig. 1 veranschaulichend als ein Pfeil 32 dargestellt ist, stets auf das zuletzt eingetragene Datum zeigt.

Die vorhergehende Beschreibung des Aufbaus sowie der Funktionsweise des Prozessors 10 betraf lediglich die lineare Abarbeitung des Programms 26, ohne daß Sprungbefehle, wie z.B. solche der Unterprogrammsprungbefehloperation 28, vorkamen. Ist der aktuell abzuarbeitende Befehl ein echter Sprungbefehl (JMP) mit dem Ziel, die Abarbeitung des Programms 26 durch den Prozessor 10 an anderer Stelle fortzusetzen, so schreibt die Befehlsverarbeitungseinrichtung 16 die in dem Sprungbefehl als Operand enthaltene Zieladresse direkt in den Programmzähler 20, so daß der nächste abzuarbeitende Befehl aus dieser Zieladresse gelesen und dem Befehlsdecodierer 18 anschließend zugeführt wird. Ist der aktuell abzuarbeitende Befehl ein Sprungbefehl mit Rücksprungeigenschaft, wie der im folgenden beschriebene Unterprogrammsprungbefehl 28, mit dem Ziel, die Abarbeitung des Programms 26 durch den Prozessor 10 für die Abarbeitung eines Unterprogramms zu unterbrechen, so legt die Befehlsverarbeitungseinrichtung 16 zunächst die in dem Programmzähler 20 eingetragene Adresse in einem Rücksprungadressenstapelspeicher ab und schreibt erst anschließend die in dem Sprungbefehl als Operand enthaltene Zieladresse in den Programmzähler 20, so daß der nächste abzuarbeitende Befehl aus dieser Zieladresse gelesen und dem Befehlsdecodierer 18 anschließend zugeführt wird und später bei Auftreten eines Rücksprungbefehls die Rücksprungadresse aus dem Stapelspeicher gelesen werden kann.

Im folgenden wird anhand der weiteren Figuren die erfindungsgemäße Funktionsweise des Prozessors 10 in dem Fall beschrieben, daß der aktuell abzuarbeitende Befehl ein Unterprogrammsprungbefehl ist bzw. einer Unterprogrammsprungbefehloperation 28 entspricht.

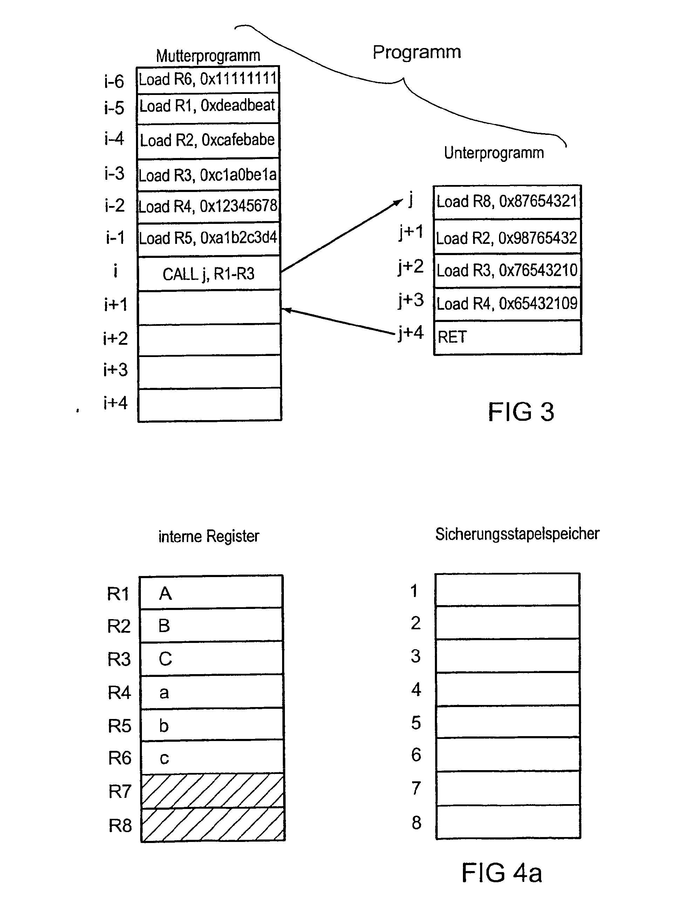

Bevor näher Bezug auf die Fig. 3 - 6 genommen wird, wird im folgenden anhand von Fig. 2 der Aufbau eines Unterprogrammsprungbefehls bzw. einer Unterprogrammsprungbefehloperation gemäß einem Ausführungsbeispiel der vorliegenden Erfindung beschrieben. Der Begriff "Unterprogrammsprungbefehloperation", wie er in der vorliegenden Beschreibung verwendet wird, unterscheidet sich von dem Begriff "Unterprogrammsprungbefehl" dadurch, daß Unterprogrammsprungbefehlsoperation mehr die Befehlsdefinition im Unterschied zu den anderen Befehlsdefinitionen der Befehlsoperationen in dem Befehlssatz des Prozessors anzeigt, während Unterprogrammsprungbefehl einer tatsächlichen Ausgestaltung der Unterprogrammsprungbefehloperation in dem abzuarbeitenden Programm entspricht. Anders ausgedrückt ist bei einer Befehlsoperation der/die Werte der Operanden unbestimmt, während bei einem Befehl alle Operanden bestimmt sind.

Im folgenden sei vereinfachend lediglich von dem Unterprogrammsprungbefehl die Rede, auch wenn die Befehlsoperation gemeint ist, da dies der übliche Sprachgebrauch ist. Der Unterprogrammsprungbefehl, der in Fig. 2 allgemein mit 34 angezeigt ist, besteht im wesentlichen aus zwei Teilen, einem Operationscode am Anfang und einem sich daran anschließenden Operandensatz. Der Operandensatz besteht wiederum aus einem Zieladreßfeld und einem Sicherungsinformationsfeld. Der Operationscode dient zur eindeutigen Identifizierung des Unterprogrammsprungbefehls 34. Diesen erhält der Befehlsdecodierer (18 in Fig. 1) des Prozessors bei Auslesen eines Befehls 34 zuerst, woraufhin der Befehlsdecodierer bereits den Operandensatz aus Zieladresse in dem Zieladreßfeld und Sicherungsinformationen in dem Sicherungsinformationsfeld erwartet. Der Befehlsdecodierer fordert folglich so lange weitere Bytes von dem Befehlsspeicher an, bis auch der vollständige Operandensatz des Befehls 34 von dem Befehlsspeicher geladen ist.

Fig. 3 zeigt einen exemplarischen Ausschnitt eines abzuarbeitenden Programms. Die rechteckigen Kästchen deuten Befehlszeilen des Programms an, wobei in jeder Befehlszeile ein Befehl enthalten ist. Wie zu sehen ist, gliedert sich das abzuarbeitende Programm in einen ersten Teil, d.h. das Mutterprogramm, und einen zweiten Teil, d.h. das Unterprogramm. Das Mutterprogramm ist linear gemäß einer Abarbeitungsreihenfolge angeordnet, wobei die Befehlszeilen exemplarisch von i-6 bis i+4 numeriert sind. Die Befehlszeilen i-6 bis i+4 des Mutterprogramms sind beispielsweise hintereinander im physikalischen Speicher des Programmspeichers gespeichert. Im Fall einer virtuellen Adreßverwaltung mittels beispielsweise einer MMU (MMU = Memory Management Unit) ist es freilich möglich, daß die lineare Anordnung des Mutterprogramms lediglich im virtuellen Adreßraum vorliegt. Ebenso wie das Mutterprogramm sind auch die Befehle bzw. Befehlszeilen des Unterprogramms linear angeordnet und exemplarisch mit j bis j+4 numeriert. Das Unterprogramm ist an anderer Stelle in dem physikalischen Programmspeicher gespeichert. Exemplarisch ist angenommen worden, daß sich in den Befehlszeilen i-6 bis i-1 Lade-(Load-) Befehle befinden, die die Register R1-R6 mit Inhalten aus externen Speicheradressen (0x...) beschreiben.

In Fig. 3 ist exemplarisch angenommen, daß sich in der Befehlszeile i des Mutterprogramms ein Unterprogrammsprungbefehl (call) befindet, der als einen ersten Operanden die Zieladresse der Befehlszeile j des Unterprogramms und als einen zweiten Operanden eine explizite Angabe zu sichernder Register ("R1-R3") aufweist. Wie bereits Bezug nehmend auf Fig. 1 beschrieben, wechselt daraufhin durch Einstellen des Programmzählers 20 (Fig. 1) auf die Zieladresse der Befehlszelle j die Abarbeitung des Programms durch den Prozessor zu dem Unterprogramm, so daß das Programm an der Befehlszeile j des Unterprogramms fortgesetzt wird. Exemplarisch ist gezeigt, daß die Befehlszeilen j bis j+3 Ladebefehle enthalten, die die Register R8 und R2 bis R4 beschreiben.

Exemplarisch zeigt Fig. 3 ferner, daß in der Befehlszeile j+4 des Unterprogramms ein Rücksprungbefehl (RET) vorgesehen ist. Der Rücksprungbefehl umfaßt lediglich einen Operationscode, nicht aber einen Operanden. Bei Auftreten des Rücksprungbefehls holt der Prozessor die Folgeadresse der Befehlszeile i+1 des Mutterprogramms, die auf die Befehlszeile des Unterprogrammsprungbefehls folgt, aus einem speziell hierfür vorgesehen Rücksprungstapelspeicher (in Fig. 1 nicht gezeigt), in welchen, wie es üblich ist, der Prozessor den Programmzählerwert beim Sprungbefehl in der Befehlszeile i eingetragen hat. Von da an wird die Abarbeitung des Programms wieder innerhalb des Mutterprogramms ab der Befehlszeile i+1 fortgeführt.

Neben diesen die Abarbeitungsreihenfolge betreffenden Maßnahmen werden bei dem Unterprogrammsprungbefehl in Zeile i und bei dem Rücksprungbefehl in Zeile j+4 auch noch Registersicherungs- bzw. -restaurierungsmaßnahmen getroffen, um die in dem Unterprogrammsprungbefehl im Rahmen der Sicherungsinformationen angegebenen Register (R1-R3), die dem Mutterprogramm nach Abarbeitung des Unterprogramms im Mutterprogramm benötigt werden, zu sichern bzw. zu restaurieren.

Um dies zu veranschaulichen, sind in Fig. 4a - 4d die Inhalte der internen Register und des Sicherungsstapelspeichers des das Programm von Fig. 3 abarbeitenden Prozessors exemplarisch gezeigt. Bei dem Ausführungsbeispiel von Fig. 4a - 4d wird der Einfachheit halber angenommen, daß es lediglich acht interne Register R1 - R8 gibt und daß der Sicherungsstapelspeicher acht Speicherplätze aufweist. Fig. 4a stellt exemplarisch den Zustand dar, der sich bis zum Auftreten des Unterprogrammsprungbefehls in der Befehlszeile i des Mutterprogramms ergeben hat. Wie es zu sehen ist, sind die internen Register R1 - R6 mit den Inhalten A, B, C, a, b und c beschrieben worden. Die Großschreibung soll andeuten, daß die Inhalte nach Abarbeitung des Unterprogramms noch benötigt werden, wohingegen die kleingeschriebenen Inhalte nicht benötigt werden, da sie beispielsweise lediglich vorübergehende Zählerwerte darstellen. Der Sicherungsstapelspeicher sei leer.

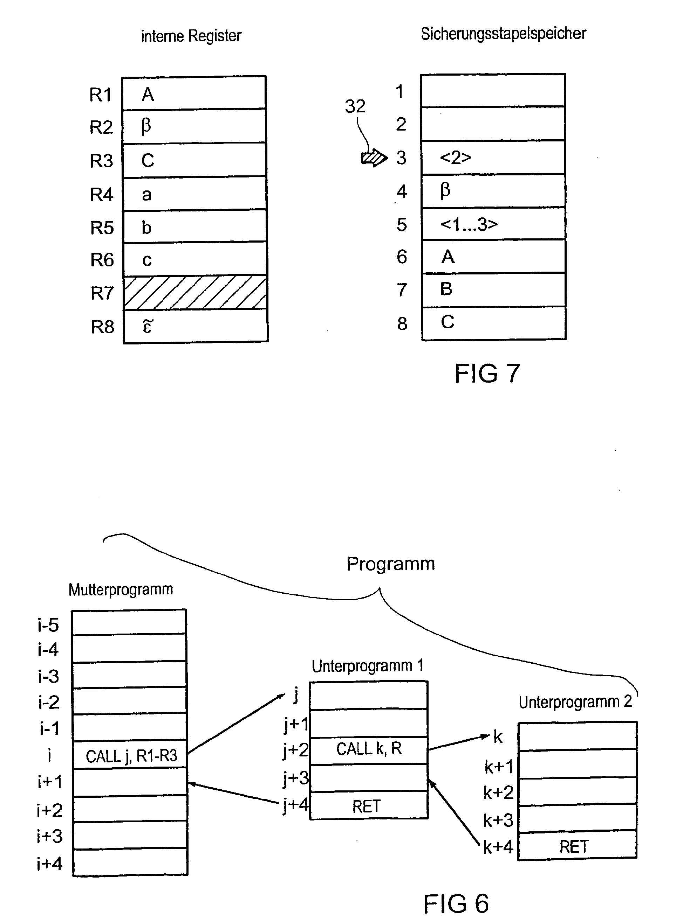

An dem Unterprogrammsprungbefehl in der Befehlszeile i angekommen, findet in dem Prozessor der in Fig. 5 gezeigte Unterprogrammsprungbefehlzyklus statt, wobei bei der Beschreibung von Fig. 5 ferner auf Fig. 1 Bezug genommen wird, wenn dies zweckdienlich ist. Sobald der Unterprogrammsprungbefehl aus der Befehlszeile i als der aktuell abzuarbeitende Befehl in den Befehlsdecodierer 18 gelangt, unterrichtet derselbe die Befehlsverarbeitungseinrichtung 16 von dem Auftreten eines Unterprogrammsprungbefehls 50. Der Befehlsdecodierer 18 sorgt ferner durch das Inkrementsignal für eine Inkrementierung des Programmzählers 20 entsprechend der Anzahl von Adreßpositionen, die der Länge des Unterprogrammsprungbefehls entspricht.

In einem Schritt 52 sorgt der Prozessor 10 dafür, daß der Programmzählerwert des Programmzählers 20 in einen Rücksprungbefehlsstapelspeicher (nicht gezeigt in Fig. 1) eingetragen wird, der der Adresse des Folgebefehls auf den Unterprogrammsprungbefehl in dem Mutterprogramm entspricht, d.h. der Adresse der Befehlszeile i+1. In einem Schritt 54 extrahiert der Befehlsdecodierer 18 die Zieladresse aus dem Unterprogrammsprungbefehl und leitet sie an die Befehlsverarbeitungseiririchtung 16 weiter. Die Befehlsverarbeitungseinrichtung 16 stellt daraufhin in einem Schritt 56 den Programmzähler 20 auf die Zieladresse ein. Auf diese Weise wird bewirkt, daß die folgende Abarbeitung des Programms am Unterprogramm fortgesetzt wird. In einem Schritt 58 extrahiert daraufhin der Befehlsdecodierer 18 die Sicherungsinformationen (R1-R3) aus dem Unterprogrammsprungbefehl. In dem Beispiel von Fig. 3 zeigen die Sicherungsinformationen an, daß die Registerinhalte der Register R1 - R3 zu sichernde Daten sind. In einem Schritt 60 sichert daraufhin die Befehlsverarbeitungseinrichtung 16 die Registerinhalte die Registerinhalte der durch die Sicherungsinformationen angezeigten Register in den Sicherungsspeicher, indem derselbe die Registerinhalte der angezeigten Register in einer vorbestimmten Reihenfolge in den Sicherungsstapelspeicher 14 (Fig. 1) einträgt. In einem Schritt 62 trägt die Befehlsverarbeitungseinrichtung 16 daraufhin die Sicherungsinformationen in den Sicherungsstapelspeicher ein. Dies dient dazu, beim Rücksprungbefehl, der keinen Operanden aufzuweisen braucht, sicherzustellen, daß bei Rekonstruktion bzw. Wiederherstellung der Registerinhalte dieselben wieder in die internen Register geschrieben werden, aus denen dieselben ursprünglich stammten.

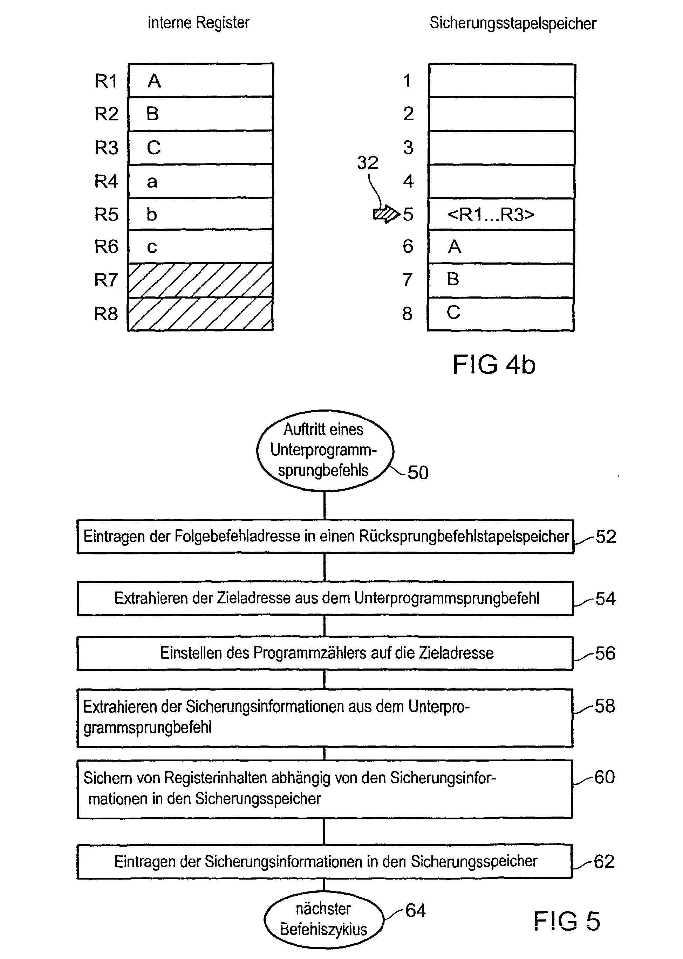

Ein Zustand, der sich nach dem Schritt 62 bei dem Beispiel von Fig. 3 einstellt, ist in Fig. 4b gezeigt. Der Sicherungsstapelspeicher enthält in den untersten Speicherplätzen 6 - 8 die Registerinhalte der durch die Sicherungsinformationen angezeigten Register R1, R2 und R3, nämlich A, B und C, wobei die Registerinhalte in der Reihenfolge größerer Registernummer zu kleinerer Registernummer in den Sicherungsstapelspeicher eingetragen wurden. In dem obersten Speicherplatz 5 des Sicherungsstapelspeichers befinden sich die Sicherungsinformationen (R1-R3).

Nach Durchführung des Unterprogrammsprungbefehlzyklus beginnt der nächste Befehlszyklus 64, der wiederum mit der Decodierung des aktuell abzuarbeitenden Befehls beginnt, in diesem Fall demjenigen Befehl, der an der Zieladresse liegt, nämlich in dem Beispiel von Fig. 3 in der Befehlszeile j des Unterprogramms.

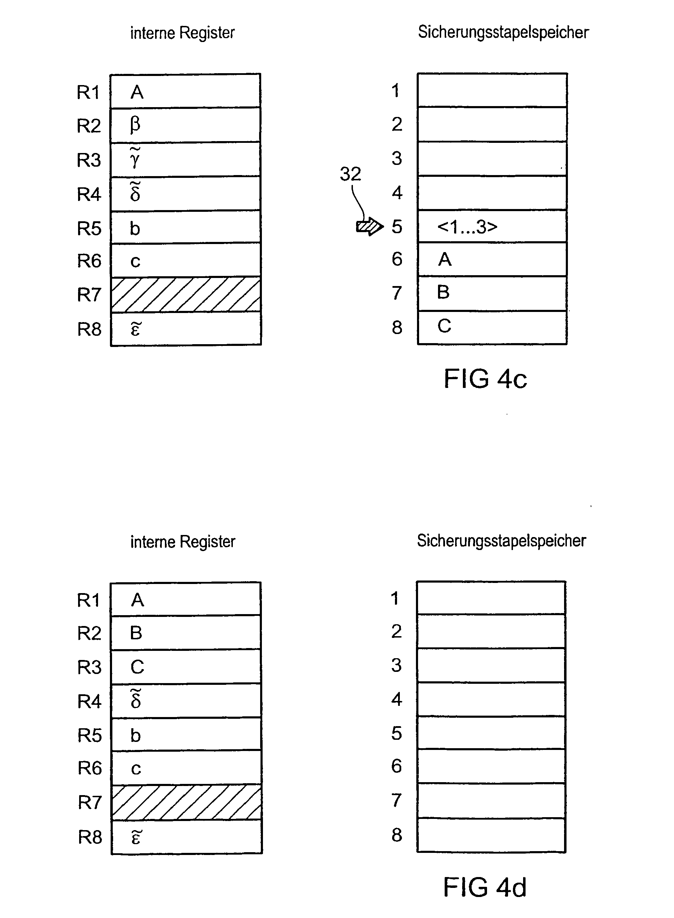

Fig. 4c zeigt den Zustand, der sich nach Abarbeitung des Unterprogramms bis Auftreten des Rücksprungbefehls in der Befehlszeile j+4 in dem Unterprogramm eingestellt hat. Wie es zu sehen ist, sind die Registerinhalte der internen Register R2 - R4 mit den Inhalten β, γ̃ und δ̃ überschrieben worden. Außerdem ist in das Register 8 der Wert ε̃ eingetragen worden.

Bei Auftreten des Rücksprungbefehls, den der Befehlsdecodierer 18 der Befehlsverarbeitungseinrichtung 16 anzeigt, liest letztere aus dem Rücksprungstapelspeicher die zuletzt, in Schritt 52, eingetragene Adresse, nämlich die Adresse der Befehlszeile i, aus und trägt dieselbe in den Programmzähler 20 ein. Ferner liest die Befehlsverarbeitungseinrichtung 16 den zuletzt eingetragenen Wert, wie er durch den Stapelspeicherzeiger 32 angezeigt wird, aus dem Sicherungsstapelspeicher, nämlich die Sicherungsinformationen des letzten Unterprogrammsprungbefehls, nämlich R1 - R3. Aus den Sicherungsinformationen erhält die Befehlsverarbeitungseinrichtung 16 insbesondere Informationen darüber, wie viele Registerinhalte bei dem letzten Unterprogrammsprungbefehl in den Sicherungsstapelspeicher eingetragen wurden bzw. wie viele Speicherplätze des Sicherungsstapelspeichers ausgelesen werden müssen, und ferner wohin diese dort gesicherten Registerinhalte geschrieben werden müssen bzw. in welche internen Register diese Registerinhalte geschrieben werden müssen. Vorliegend zeigen die Sicherungsinformationen an, daß drei Registerinhalte aus dem Sicherungsstapelspeicher zu lesen sind, nämlich A, B und C. Ferner zeigen die Sicherungsinformationen durch die Konvention der Eintragungsreihenfolge beim Sichern (Schritt 60) der zu sichernden Registerinhalte in den Sicherungsstapelspeicher an, welche gesicherten Registerinhalte in welche internen Register geschrieben werden sollen, nämlich vorliegend A in R1, B in R2 und C in R3.

Der sich ergebende Zustand ist in Fig. 4d gezeigt. Die internen Register R1 - R3, in die vor Unterprogrammaufruf bei Abarbeitung des Mutterprogramms Zwischenergebnisse gespeichert wurden, die nach dem Unterprogramm zur Verfügung stehen sollten, sind bezüglich ihrer Registerinhalte wiederhergestellt bzw. restauriert worden. Der Registerinhalt R4 unterscheidet sich von demjenigen vor dem Unterprogrammaufruf, was jedoch unerheblich ist, da er je zur weiteren Ausführung des Mutterprogramms nicht benötigt wird (ansonsten wäre R4 in den Sicherungsinformationen enthalten gewesen). Der Sicherungsstapelspeicher ist wieder leer.

In Fig. 6 ist ein weiteres Ausführungsbeispiel eines abzuarbeitenden Programms gezeigt, das lediglich dazu dient, zu veranschaulichen, daß Unterprogrammausführungen ineinander verschachtelt sein können, d.h. daß aus einem aufgerufenen Unterprogramm ein weiteres Unterprogramm aufgerufen werden kann. Das Ausführungsbeispiel von Fig. 6 unterscheidet sich von demjenigen von Fig. 3 lediglich dadurch, daß angenommen wird, daß in der Befehlszeile j+2 des Unterprogramms ein weiterer Unterprogrammsprungbefehl vorliegt. Der Inhalt der internen Register R1 - R8 und der Speicherplätze des Sicherungsstäpelspeichers, die sich nach der Abarbeitung des Sprungbefehls in der Befehlszeile j+2 ergeben, sind in Fig. 7 gezeigt.

In dem Unterprogramm von den Zeilen j bis j+4, welches sich zu dem aufgerufenen Unterprogramm von den Befehlszeilen k bis k+4 wie ein Mutterprogramm verhält, ist bis zu dem Auftreten des Unterprogrammsprungbefehls in der Befehlszeile j+2 bereits der Inhalt der Register R2 und R8 auf β und ε̃ verändert worden. Der Zirkumflex soll andeuten, daß der entsprechende Inhalt im Register nach Ausführung des aufgerufenen Unterprogramms zweiter Aufrufhierarchie (k bis k+4) in dem Unterprogramm erster Aufrufhierarchie (j bis j+4) anschließend nicht benötigt wird. Dementsprechend enthält der Unterprogrammsprungbefehl in der Befehlszeile j+2 als Sicherungsinformationen lediglich solche, die das Register R2 anzeigen. Dementsprechend ist bei Abarbeitung des Unterprogrammsprungbefehls der Registerinhalt des angezeigten internen Registers R2 in den Sicherungsstapelspeicher auf den nächsten freien Platz in dem Sicherungsstapelspeicher eingetragen worden, nämlich den Speicherplatz 4. Zudem wurden die Sicherungsinformationen des zweiten Unterprogrammsprungs, nämlich R2, in den letzten bzw. obersten Speicherplatz des Sicherungsstapelspeichers eingetragen, auf welchen auch der Stapelspeicherzeiger 32 zeigt. Auf diese Weise werden auch bei verschachtelten Unterprogrammen die zu sichernden Daten der jeweiligen Mutterprogramme "gespeichert", wobei durch die zusätzliche Speicherung der jeweiligen Sicherungsinformationen eine korrekte Restaurierung bzw. Wiederherstellung der Registerinhalte bei den aufeinanderfolgenden Rücksprüngen gewährleistet ist.

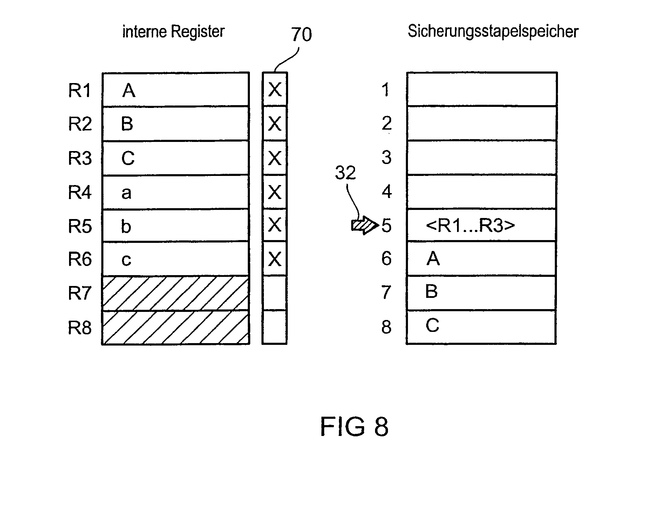

Bei den vorhergehenden Ausführungsbeispielen dienten ausschließlich die Sicherungsinformationen in dem Unterprogrammsprungbefehl zur eindeutigen Identifizierung derjeniger internen Register, deren Registerinhalte in den Sicherungsspeicher 14 zu speichern waren. Durch die explizite Angabe der zu sichernden Register standen damit, einen begrenzten Satz an Registern vorausgesetzt, auch immer gleichzeitig die nicht zu sichernden Register fest als diejenigen, die nicht zu den angegebenen gehörten. In dem Bezug nehmend auf Fig. 8 beschriebenen Ausführungsbeispiel werden die Sicherungsinformationen mit automatisch aktualisierten Protokollierungsinformationen verknüpft, um die zu sichernden Registerinhalte anzuzeigen. Fig. 8 zeigt den Zustand der internen Register R1 - R8 und des Sicherungsstapelspeichers, wie er sich bei Abarbeitung des Programms von Fig. 3 nach Abarbeitung des Unterprogrammsprungbefehls in Zeile i ergibt, wobei jedoch eine automatische Erkennung benutzter interner Register verwendet wird, wie sie im folgenden beschrieben wird.

Wie es zu sehen ist, stellt sich in den internen Registern und in dem Sicherungsstapelspeicher derselbe Zustand ein, wie bei dem Ausführungsbeispiel, welches Bezug nehmend auf die Fig. 4a - 4d beschrieben worden ist, nämlich der gleiche Zustand wie in Fig. 4b. Zusätzlich ist in Fig. 8 jedoch ein Register 70 gezeigt, in welchem eine Flag pro Register vorgesehen ist. Die Befehlsverarbeitungseinrichtung 16 ist bei diesem Ausführungsbeispiel derart ausgebildet, daß sie bei jeder Speicherung eines Zwischenergebnisses in einem der internen Register R1 - R8 die diesem Register entsprechende Flag setzt, falls sie nicht bereits gesetzt ist. In dem vorliegenden Fall sind, wie es durch kleine Kreuzchen angezeigt ist, die Flags der bis daher verwendeten Register R1 - R6 gesetzt.

Bei dem Ausführungsbeispiel von Fig. 8 zeigen jedoch die Sicherungsinformationen des Unterprogrammsprungbefehls in der Befehlszeile i nicht explizit diejenigen Register an, die gesichert werden sollen, sondern lediglich diejenigen, die explizit von der Sicherung ausgeschlossen werden sollen, da sie bei der weiteren Abarbeitung des Mutterprogramms nach Abarbeitung des Unterprogramms nicht benötigt werden, vorliegend also die Register R4 - R8. Dementsprechend unterscheidet sich der Unterprogrammsprungbefehlzyklus von dem Bezug nehmend auf Fig. 5 beschriebenen lediglich darin, daß bei dem Schritt des Eintragens 62 nicht die Sicherungsinformationen selbst in dem Sicherungsstapelspeicher gespeichert werden, die ja lediglich die nicht zu sichernden Register R4-R8 angeben, sondern die durch die automatische Erkennung bzw. die gesetzten Flags angezeigten Register R1-R6 abzüglich derjeniger, die durch die Sicherungsinformationen explizit von der Sicherung ausgeschlossen sind, nämlich R4-R8. In diesem Fall ergeben sich also wie bei dem Ausführungsbeispiel von Fig. 4a - 4d die Register R1 - R3, d.h. alle nicht von der Sicherung ausgeschlossenen Register, die vor Auftreten des Unterprogrammsprungbefehls verwendet wurden.

Nachdem im Vorhergehenden anhand der Figuren das erfindungsgemäße Konzept der Sicherung von Daten während der Abarbeitung von Unterprogrammen anhand von Ausführungsbeispielen eher veranschaulichend beschrieben worden ist, werden im folgenden speziellere Ausführungsbeispiele für unterprogrammsprungbefehle geliefert, welche sich entweder durch die Codierung der Sicherungsinformationen in dem Sicherungsinformationsfeld (siehe Fig. 2) oder die Art und Weise, wie dieselben in der Befehlsverarbeitungseinrichtung 16 interpretiert werden, unterscheiden.

Wie bei dem Ausführungsbeispiel von Fig. 4a - 4d bereits beschrieben, besteht eine erste Möglichkeit der Angabe der zu sichernden Registerinhalte in der expliziten Angabe der zu sichernden Registerinhalte bzw. der expliziten Angabe derjeniger Register, deren Registerinhalte zu sichern sind. Ein Unterprogrammsprungbefehl dieser Art könnte in üblicher Notation, beispielsweise wie in Fig. 3 gezeigt, als "call <Sprungadresse>, Rx, Ry, ..." geschrieben werden, ein Unterprogrammsprungbefehl, der die Fortführung der Programmabarbeitung an der Zieladresse bzw. Sprungadresse mit Sicherung der Registerinhalte in den Registern Rx, Ry, ... zur Folge hat.

Eine weitere Möglichkeit besteht darin, daß die Sicherungsinformationen des Unterprogrammsprungbefehls die explizit nicht zu sichernden Registerinhalte bzw. diejenigen Register anzeigen, deren Registerinhalte nicht gesichert werden sollen, wie es beispielsweise bei dem Ausführungsbeispiel von Fig. 8 der Fall war. Eine mögliche Schreibweise für einen solchen Unterprogrammsprungbefehl wäre beispielsweise "call <Zieladresse>, /rx, /ry, ...", ein Unterprogrammsprungbefehl, der einen Sprung zur Zieladresse und die Sicherung aller oder im Fall der automatischen Erkennung verwendeter Register, aller verwendeten internen Register mit Ausnahme der mit "/" markierten Register zur Folge hätte.

Bei beiden vorhergehenden Ausführungsbeispielen, also bei demjenigen, bei dem explizit die zu sichernden Registerinhalte angezeigt werden, und demjenigen, bei dem explizit die nicht zu sichernden Registerinhalte angezeigt werden, können die Sicherungsinformationen aus einer Maske bestehen, die ein Bit pro Register aufweist, bei den Beispielen von Fig. 4a-4c also beispielsweise 8 Bits. Jedes Bit ist einem Register zugeordnet. Bei expliziter Angabe der zu sichernden Register könnten die Bits, die mit einem zu sichernden Register verknüpft sind, beispielsweise einen logisch hohen Zustand aufweisen, während die Bits, die mit den anderen Registern verknüpft sind, einen logisch niedrigen Zustand aufweisen. Bei expliziter Angabe der von der Sicherung auszuschließenden Register könnten die Bits, die mit einem nicht zu sichernden Register verknüpft sind, beispielsweise einen logisch hohen Zustand aufweisen, während die Bits, die mit den anderen Registern verknüpft sind, einen logisch niedrigen Zustand aufweisen. Die Sicherungsinformationen des Unterprogrammsprungbefehls des Ausführungsbeispiels von Fig. 3 könnten dann beispielsweise durch die Maske "11100000" und diejenigen des Unterprogrammsprungbefehls des Ausführungsbeispiels von Fig. 8 durch die Maske von "00011111" angezeigt werden, wobei jeweils das erste Bit von links dem Register R1, das zweite Bit von links dem Register R2 usw. zugeordnet ist. Bei diesem Ausführungsbeispiel bestünde also das Sicherungsinformationsfeld des Befehls aus einer Maske, die von Unterprogrammsprungbefehl zu Unterprogrammsprungbefehl unterschiedlich ist. Diese Maske könnte dazu dienen, in dem Sicherungsstapelspeicher abgelegt zu werden (Schritt 62).

Anstelle der Maskenbit-Register-Zuordnung des vorhergehenden Ausführungsbeispiels ist es ferner möglich, zur Codierung der explizit zu sichernden bzw. explizit nicht zu sichernden Registerinhalte eine Ordnung unter den internen Registern zu definieren, die dann zu einer effizienteren, weniger Bits benötigenden Codierung ausgenutzt werden kann. Eine einfache Variante dieses Prinzips besteht in der einfachen linearen Sortierung der internen Register. Bei den vorhergehenden Ausführungsbeispielen sind die Register beispielsweise durch ihre Numerierung linear geordnet.

Bei diesem Ausführungsbeispiel weisen dann die Sicherungsinformationen beispielsweise lediglich die Angabe eines Registers bzw. eines Ordnungsrangs auf. Per Konvention bzw. Definition der Unterprogrammsprungbefehlsoperation weiß dann die Befehlsverarbeitungseinrichtung beispielsweise, daß zusammen mit dem durch die Sicherungsinformationen angezeigten Register alle Register höherer Ordnung bzw. Register mit höherem Index oder, alternativ, alle Register niedrigerer Ordnung bzw. mit niedrigem Index als explizit angegeben gelten sollen, um als zu sichernd bzw. nicht zu sichernd zu gelten. Bei dem Ausführungsbeispiel von Fig. 4a - 4d genügt es beispielsweise, wenn die Sicherungsinformationen das Register R3 angeben, wodurch die Befehlsverarbeitungseinrichtung beispielsweise per Konvention alle Register mit niedrigerem Index, d.h. R1 und R2, zusammen mit dem angegebenen Register R3 in dem Sicherungsspeicher sichert. Eine tatsächliche Codierung der Sicherungsinformationen wäre dann beispielsweise ein binäres Vier-Bit-Wort von "0011", d.h. die binäre Codierung von 3. Bei dem Ausführungsbeispiel von Fig. 8 reichte es beispielsweise aus, wenn die Sicherungsinformationen des Unterprogrammsprungbefehls das Register R4 angeben, woraus die Befehlsverarbeitungseinrichtung beispielsweise per Konvention mit dem angegebenen Register alle Register mit gleichem oder höherem Index von der Sicherung ausschließt. In diesem Fall könnten die Sicherungsinformationen durch das Bitwort "0100" codiert werden, d.h. die binäre Darstellung von 4.

Freilich sind auch andere Anordnungsschemata als die lineare, die im vorhergehenden beschrieben wurde, für die internen Register möglich und je nach Einsatz und Architektur des Prozessors möglicherweise auch zu bevorzugen. Bei der 88er Architektur existieren beispielsweise in dem Prozessor 16 Adreßregister und getrennt hiervon 16 Datenregister. In diesem Fall könnte sich das Sicherungsinformationsfeld (siehe Fig. 2) in zwei Teilfelder gliedern, von denen in dem einen Sicherungsinformationen für die Adreßregister und in dem anderen Sicherungsinformationen für die Datenregister enthalten sind. Die Codierung und Konvention bezüglich der Interpretierung der Sicherungsinformationen für die beiden Registertypen wäre freilich gemäß aller der im Vorhergehenden beschriebenen Ausführungsbeispiele möglich. Ein Befehl von beispielsweise call <Sprungadresse>, D5, A13, könnte beispielsweise anzeigen, daß alle Datenregister Dx mit einem Index größer oder gleich 5 und alle Adreßregister mit einem Index von 13 oder größer in dem Sicherungsstapelspeicher gesichert werden.

Ein Fachmann wird leicht verstehen, daß die obigen Ausführungsbeispiele in einem Prozessor nach Bedarf kombiniert werden könnten. In dem Befehlssatz des Prozessors könnte entweder lediglich ein erfindungsgemäßer Unterprogrammsprungbefehl enthalten sein, dessen Codierung und Interpretation an die Anwendung des Prozessors angepaßt ist. Es könnten jedoch ferner auch mehrere Unterprogrammsprungbefehltypen in dem Befehlssatz vorhanden sein, die sich dann durch ihren Operationscode unterscheiden. Anhand des Operationscodes kann dann die Befehlsverarbeitungseinrichtung entscheiden, wie die Sicherungsinformationen zu interpretieren sind, also erstens, ob als Bitmaske oder binäre Angabe eines Registerindexes, ab oder bis welchem alle Register explizit als angegeben gelten, zweitens ob als explizite Angabe der zu sichernden (Fig. 4) oder der nicht zu sichernden (Fig. 8) Register, und drittens ob als mit den die verwendeten Register angebenden Flags zu verknüpfende (Fig. 8) oder eigenständige (Fig. 4) Angabe.

Mit den im Vorhergehenden beschriebenen Ausführungsbeispielen zur Sicherung von Registerinhalten während der Ausführung von Unterprogrammen kann folglich eine Optimierung der Befehlssequenz in dem Programm zur automatischen Sicherung von Kontextdaten beim Aufruf von Unterprogrammen erzielt werden. Insbesondere ermöglichen es die Ausführungsbeispiele, die zu sichernden Daten effizient, also mit geringer Codelänge, auszuwählen. Die dargestellten Unterprogrammsprungbefehle bzw. Programmverzweigungsbefehle beinhalteten als Operanden neben der obligatorischen Zieladresse einen oder mehrere Parameter zur Identifikation der zu sichernden Daten, die mit der Ausführung des Befehls eine automatische Sicherung initiieren. Durch eine geschickte Organisation der Datenablage kann der Speicherbedarf zur Sicherung der Daten optimiert werden.

Insbesondere bei der vorgenannten Definition einer linearen Ordnung unter den internen Registern und der expliziten Angabe explizit nicht zu sichernder oder zu sichernder Registerinhalte durch Angabe lediglich eines Registerindexes kann eine optimale Nutzung der Sicherungsstapelspeicherkapazität erzielt werden, indem beispielsweise Daten, die nach Ausführung des Unterprogramms benötigt werden, ausgehend von dem niedrigsten Index in die Register geschrieben werden, während Daten, die nach Ausführung des Unterprogramms nicht benötigt werden, ausgehend von dem Register mit höchstem Index in die Register geschrieben werden.

Gegenüber der in der Beschreibungseinleitung beschriebene Möglichkeit der automatischen Erkennung der benutzten Register zur Bestimmung der zu sichernden Registerinhalte ergibt sich der Vorteil, daß Softwarewerkzeugen, wie z.B. Compilern, bei der Erstellung der Befehlssequenzen bzw. des eigentlichen Programmcodes eine bessere Ausnutzung des Sicherungsspeichers bei gleichem Bedarf an Programmcodespeicher ermöglicht wird. Bei dem Ausführungsbeispiel von Fig. 8, bei dem die automatische Erkennung benutzter Register beispielsweise mit der expliziten Angabe von nicht zu sichernden Registerinhalten verknüpft wurde, wird beispielsweise das Speichern von Daten vermieden, die lediglich zeitweise notwendig sind, nicht aber nach Ausführung des Unterprogramms.

Die Erfindung ermöglicht folglich eine Optimierung des Speicherbedarfs für den Programmcode eines Prozessors auf der einen Seite und eine gleichzeitige Verringerung des Bedarfs an Datenspeicher für zu sichernde Daten bei Benutzung von Programmverzweigungsbefehlen auf der anderen Seite.

Bezug nehmend auf die vorhergehende Beschreibung wird noch darauf hingewiesen, daß, obwohl im Vorhergehenden lediglich interne Register des Prozessors Gegenstand der Sicherung während der Ausführung von Unterprogrammen waren, ferner Speicherplätze jeglicher Art Speicherort der gegebenenfalls zu sichernden Informationen bzw. Daten sein können. Ferner könnte auch der Sicherungsstapelspeicher in dem Prozessor selbst angeordnet sein. Ferner könnte der Sicherungsstapelspeicher auch anders als nach dem Stapel- bzw. Kellerspeicherprinzip arbeiten. Außerdem existieren verschiedene andere Möglichkeiten der Verwaltung des Programmzählers und der Definition von Befehlsoperationen. Außerdem könnten Codierungsschemata mit variabler Länge zur Kodierung der explizit als zu sichernd bzw. nicht zu sichernd angegebenen Register verwendet werden.

### Bezugszeichenliste

- 10: Prozessor
- 12: Programmspeicher
- 14: Sicherungsspeicher
- 16: Verarbeitungseinrichtung
- 18: Befehlsdekodierer
- 20: Programmzähler
- 22: Register
- 24: Befehlssatz
- 26: Programm
- 28: Unterprogrammsprungbefehl
- 30: Busschnittstelle
- 32: Stapelspeicherzeiger
- 34: Unterprogrammsprungbefehl
- 70: Protokollierungsflags

## Patentansprüche

1. Prozessor zur Abarbeitung eines Programms (26) mit Befehlen, das ein Mutterprogramm mit einem Unterprogrammsprungbefehl und ein Unterprogramm aufweist, das ansprechend auf den Unterprogrammsprungbefehl auszuführen ist, mit
einer Befehlsverarbeitungseinrichtung (16);
einem Befehlsdecodierer (18), der bei Auftreten des Unterprogrammsprungbefehls in dem Mutterprogramm ausgebildet ist, um
aus dem Unterprogrammsprungbefehl Sicherungsinformationen über nach der Abarbeitung des Unterprogramms im Mutterprogramm benötigte Daten zu extrahieren;
aus dem Unterprogrammsprungbefehl eine Zieladresse zu extrahieren, die auf das Unterprogramm verweist; und
der Befehlsverarbeitungseinrichtung (16) das Auftreten des Unterprogrammsprungbefehls in dem Mutterprogramm sowie die Sicherungsinformationen und die Zieladresse mitzuteilen,
wobei die Befehlsverarbeitungseinrichtung (16) ausgebildet ist, um das Auftreten des Unterprogrammsprungbefehls in dem Mutterprogramm hin
auf der Grundlage der Sicherungsinformationen die nach der Abarbeitung des Unterprogramms im Mutterprogramm benötigten Daten zu sichern; und
auf der Grundlage der Zieladresse zu bewirken, daß die Abarbeitung des Programms mit dem Unterprogramm fortgesetzt wird.

2. Prozessor gemäß Anspruch 1, wobei der Prozessor einen Befehlssatz (24) aus mehreren durch Operationscodes eindeutig identifizierbaren Befehlsoperationen aufweist, wobei sich unter den Befehlsoperationen eine Unterprogrammsprungbefehlsoperation befindet, die durch einen Unterprogrammsprungbefehloperationscode eindeutig identifiziert ist, und bei dem jeder Befehl des Programms einen Operationscode aufweist, durch welchen derselbe einer der Befehlsoperationen zugeordnet werden kann, wobei der Befehlsdecodierer (18) ausgebildet ist, um einen aktuell abzuarbeitenden Befehl des Mutterprogramms zu decodieren, um den Operationscode desselben zu erhalten, und das Auftreten des Unterprogrammsprungbefehls an die Befehlsverarbeitungseinrichtung (16) zu melden, falls der Operationscode desselben gleich dem Unterprogrammsprungbefehloperationscode ist, und wobei der Unterprogrammsprungbefehl als Operanden die Zieladresse und die Sicherungsinformationen aufweist.

3. Prozessor gemäß Anspruch 2, bei dem unter den Befehlen des Mutterprogramms und des Unterprogramms jeweils eine Abarbeitungsreihenfolge definiert ist, mit welcher der Prozessor ausgebildet ist, die Abarbeitung des Programms durchzuführen, wobei jeder Befehl genau einen Operationscode aufweist, durch welchen derselbe einer der Befehlsoperationen zugeordnet werden kann.

4. Prozessor gemäß Anspruch 3, wobei der Prozessor ausgebildet ist, um jeden Befehl des Programms in einem von aufeinanderfolgenden Befehlszyklen auszuführen, wobei der Befehlsdecodierer (18) und die Befehlsverarbeitungseinrichtung (16) ausgebildet sind, um die Extraktion, die Sicherung und das Bewirken in einem einzigen Befehlszyklus auszuführen.

5. Prozessor gemäß einem der Ansprüche 1 bis 4, der ferner folgendes Merkmal aufweist:
Speicherplätze (22) zum Speichern von Prozessorzwischenergebnissen während der Abarbeitung des Programms, wobei sich die nach der Abarbeitung des Unterprogramms im Mutterprogramm benötigten Daten aus den Prozessorzwischenergebnissen einer Auswahl der Speicherplätze zusammensetzen, wobei die Auswahl von den Sicherungsinformationen abhängt.

6. Prozessor gemäß Anspruch 5, bei dem die Sicherungsinformationen zumindest einen Speicherplatz (22) anzeigen, der zur Auswahl gehört, wobei kein anderer Speicherplatz zur Auswahl gehört.

7. Prozessor gemäß Anspruch 5, bei dem die Sicherungsinformationen zumindest einen Speicherplatz (22) anzeigen, der nicht zur Auswahl gehört.

8. Prozessor gemäß Anspruch 7, bei dem alle anderen Speicherplätze zur Auswahl gehören.

9. Prozessor gemäß Anspruch 7, bei dem die Auswahl zusätzlich von Benutzungsinformationen abhängt, die anzeigen, welcher der Speicherplätze während der Abarbeitung des Mutterprogramms bis zum Auftreten des Unterprogrammsprungbefehls zur Speicherung von Zwischenergebnissen verwendet wurde, derart, daß die Auswahl diejenigen Speicherplätze umfaßt, die durch die Benutzungsinformationen als während der Abarbeitung des Mutterprogramms bis zum Auftreten des Unterprogrammsprungbefehls verwendet angezeigt werden und gleichzeitig nicht zu den Speicherplätzen gehören, die durch die Sicherungsinformationen angezeigt werden.

10. Prozessor gemäß einem der Ansprüche 1 bis 9, bei dem die Befehlsverarbeitungseinrichtung (16) ausgebildet ist, um bei der Sicherung der nach der Abarbeitung des Unterprogramms im Mutterprogramm benötigten Daten die Daten in einem Stapelspeicher (14) einzutragen.

11. Prozessor gemäß Anspruch 10, bei dem die Befehlsverarbeitungseinrichtung (16) ausgebildet ist, um beim Ablegen der Daten in dem Stapelspeicher (14) zusammen mit den Daten auch die Sicherungsinformationen abzulegen.

12. Prozessor gemäß einem der Ansprüche 2 bis 11, bei dem das Unterprogramm einen Rücksprungbefehl aufweist und bei dem der Befehlssatz (24) ferner eine Rücksprungbefehlsoperation aufweist, die durch einen eindeutigen Rücksprungbefehlsoperationscode identifizierbar ist, wobei der Befehlsdecodierer (18) ausgebildet ist, um in dem Fall, daß der Operationscode des aktuell abzuarbeitenden Befehls mit dem Rücksprungbefehlsoperationscode übereinstimmt, der Befehlsverarbeitungseinrichtung (16) das Auftreten des Rücksprungbefehls zu melden, wobei die Befehlsverarbeitungseinrichtung (16) ausgebildet ist, um bei Auftreten des Rücksprungbefehls die gesicherten Daten auf der Grundlage der gespeicherten Sicherungsinformationen wiederherzustellen.

13. Prozessor gemäß einem der Ansprüche 1 bis 12, bei dem die Sicherungsinformationen ein Bitwort umfassen, das eine Mehrzahl von Bits aufweist, von denen jedes einem der Speicherplätze (22) zugewiesen ist, wobei alle Bits, die Speicherplätzen zugewiesen sind, die gespeichert werden sollen, oder alle Bits, die Speicherplätzen zugewiesen sind, die nicht gespeichert werden sollen, einen ersten logischen Zustand aufweisen, während die anderen Bits einen zweiten, von den ersten Bits entgegengesetzten logischen Zustand aufweisen.

14. Prozessor gemäß Anspruch 14, bei dem die Befehlsverarbeitungseinrichtung (16) ausgebildet ist, um bei der Sicherung die Zwischenergebnisse derjeniger Speicherplätze zu sichern, die Bits zugeordnet sind, die den ersten logischen Zustand aufweisen, und die Zwischenergebnisse derjeniger Speicherplätze nicht zu sichern, die Bits zugeordnet sind, die den zweiten logischen Zustand aufweisen, oder umgekehrt die Zwischenergebnisse derjeniger Speicherplätze nicht zu sichern, die Bits zugeordnet sind, die den ersten logischen Zustand aufweisen, und die Zwischenergebnisse derjeniger Speicherplätze zu sichern, die Bits zugeordnet sind, die den zweiten logischen Zustand aufweisen.

15. Prozessor gemäß einem der Ansprüche 5 bis 12, bei dem unter den Speicherplätzen (22) eine Rangordnung definiert ist, die Sicherungsinformationen einen Speicherplatz mit bestimmtem Rang anzeigen, und die Speicherplätze, die gesichert werden sollen, oder die Speicherplätze, die nicht gesichert werden sollen, die Speicherplätze entweder höheren oder niedrigeren Rangs als dem bestimmten Rang sind.

16. Prozessor gemäß Anspruch 15, bei dem die Befehlsverarbeitungseinrichtung (16) ausgebildet ist, um beim Sichern die Zwischenergebnisse derjeniger Speicherplätze zu speichern, die höheren Rangs als dem bestimmten Rang sind, und die Zwischenergebnisse derjeniger Speicherplätze nicht zu speichern, die niedrigeren Rangs als dem bestimmten Rang sind, oder umgekehrt die Zwischenergebnisse derjeniger Speicherplätze nicht zu speichern, die höheren Rangs als dem bestimmten Rang sind, und die Zwischenergebnisse derjeniger Speicherplätze zu speichern, die niedrigeren Rangs als dem bestimmten Rang sind.

17. Prozessor gemäß einem der Ansprüche 1 bis 13 oder 15, der ferner folgendes Merkmal aufweist:
eine Protokollierungseinrichtung zum Setzen einer Markierung für jeden Speicherplatz (22), in welchem während der Ausführung des Mutterprogramms ein Zwischenwert gespeichert wurde,
wobei die Befehlsverarbeitungseinrichtung (16) ausgebildet ist, um beim Sichern die Zwischenergebnisse derjenigen Speicherplätze zu sichern, für die eine Markierung gesetzt ist, abzüglich der Zwischenergebnisse derjeniger Speicherplätze, die durch die Sicherungsinformationen angegeben sind.

18. Prozessor gemäß Anspruch 17, bei dem die Befehlsverarbeitungseinrichtung ausgebildet ist, um beim Ablegen der Daten in dem Stapelspeicher zusammen mit den Daten auch die Sicherungsinformationen abzulegen.

19. Verfahren zur Abarbeitung eines Programms mit Befehlen, das ein Mutterprogramm mit einem Unterprogrammsprungbefehl und ein Unterprogramm aufweist, das ansprechend auf den Unterprogrammsprungbefehl auszuführen ist, wobei das Verfahren folgende Schritte aufweist:
bei Auftreten des Unterprogrammsprungbefehls in dem Mutterprogramm, durch einen Befehlsdecodierer,
Extrahieren von Sicherungsinformationen über nach der Abarbeitung des Unterprogramms im Mutterprogramm benötigte Daten aus dem Unterprogrammsprungbefehl; und
Extrahieren einer Zieladresse aus dem Unterprogrammsprungbefehl, wobei die Zieladresse auf das Unterprogramm verweist,
und durch eine Befehlsverarbeitungseinrichtung,
Sichern der nach der Abarbeitung des Unterprogramms im Mutterprogramm benötigten Daten auf der Grundlage der Sicherungsinformationen; und
Bewirken auf der Grundlage der Zieladresse, daß die Abarbeitung des Programms mit dem Unterprogramm fortgesetzt wird.

20. Computerprogramm mit einem Programmcode zur Durchführung des Verfahrens gemäß Anspruch 19, wenn das Computerprogramm auf einem Computer abläuft.

## Claims

1. A processor for processing a program (26) with commands, which comprises a mother program with a sub-program jump command and a sub-program, which is to be executed in response to the sub-program jump command, comprising
a command processing means (16);
a command decoder (18) adapted to, upon the occurrence of the sub-program jump command in the mother program,
extract, from the sub-program jump command, back-up information about data required in the mother program after processing the sub-program;
extract a destination address referring to the sub-program from the sub-program jump command;
report the occurrence of the sub-program jump command in the mother program as well as the back-up information and the destination address to the command processing means (16),
wherein the command processing means (16) is adapted to, upon the occurrence of the sub-program jump command in the mother program,
back-up, based on the back-up information, the data required in the mother program after processing the sub-program; and
effect, based on the destination address, the processing of the program to be continued with the sub-program.

2. The processor according to claim 1, wherein the processor has a command set (24) of several command operations clearly identifiable by operation codes, wherein a sub-program jump command operation is among the command operations, which is identified clearly by a sub-program jump command operation code, and wherein every command of the program has an operation code, by which it can be associated to a command operation, wherein the command decoder (18) is adapted to decode a currently to be processed command of the mother program to obtain its operation code, and to report the occurrence of the sub-program jump command to the command processing means (16), if its operation code is equal to the sub-program jump command operation code, and wherein the sub-program jump command has the destination address and the back-up information as operands.

3. The processor according to claim 2, wherein among the commands of the mother program and the sub-program an execution order is defined, respectively, and the processor is adapted to perform, based on the execution order, processing the program, wherein every command has exactly one operation code, by which it can be associated to one of the command operations.

4. The processor according to claim 3, wherein the processor is adapted to perform every command of the program in one of the successive command cycles, wherein the command decoder (18) and the command processing means (16) are adapted to perform extraction, back-up and effecting in a single command cycle.

5. The processor according to one of claims 1 to 4, further comprising:
memory locations (22) for storing processing means intermediate results during processing the program, wherein the data required in the mother program after processing the sub-program are made up of the processing means intermediate results of the selection of memory locations, wherein the selection depends on the back-up information.

6. The processor according to claim 5, wherein the back-up information indicates at least one memory location (22) which belongs to the selection, wherein no other memory location belongs to the selection.

7. The processor according to claim 5, wherein the back-up information indicates at least one memory location (22), which does not belong to the selection.

8. The processor according to claim 7, wherein all other memory locations belong to the selection.

9. The processor according to claim 7, wherein the selection depends additionally on usage information, which indicates which of the memory locations has been used for storing intermediate results during the processing of the mother program until the occurrence of the sub-program jump command, such that the selection comprises those memory locations, which are indicated by the usage information as used during processing the mother program until the occurrence of the sub-program jump command and simultaneously do not belong to the memory locations, which are indicated by the back-up information.

10. The processor according to one of claims 1 to 9, wherein the command processing means (16) is adapted to enter the data into a stack memory (14) in the back-up of the data required after processing the sub-program in the mother program.

11. The processor according to claim 10, wherein the command processing means (16) is adapted to enter the back-up information together with the data during entering the data in the stack memory (14).

12. The processor according to one of claims 2 to 11, wherein the sub-program comprises a return command and wherein the command set (24) further comprises a return command operation, which can be identified by a unique return command operation code, wherein the command decoder (18) is adapted to report the occurrence of the return command to the command processing means (16), in the case that the operation code of the currently to be processed command matches the return command operation code, wherein the command processing means is adapted to restore the backed-up data based on the stored backed-up information upon occurrence of the return command.

13. The processor according to one of claims 1 to 12, wherein the back-up information comprises a bit word, which comprises a plurality of bits, each of which is associated to one of the memory locations (22), wherein all bits, which are associated to memory locations, which are to be stored, or all bits, which are associated to memory locations, which are not to be stored, have a first logic state, while the other bits have a second logic state opposite to the one of the first bits.

14. The processor according to claim 14, wherein the command processing means (16) is adapted to back-up intermediate results of those memory locations during back up, which are associated to bits which have the first logic state, and to not back up intermediate results of those memory locations which are associated to bits, which have the second logic state, or, on the contrary, to not back-up the intermediate results of those memory locations, which are associated to bits, which have the first logic state, and to back-up the intermediate results of those memory locations, which are associated to bits which have the second logic state.

15. The processor according to one of claims 5 to 12, wherein a ranking is defined among the memory locations (22), which indicates a memory location with a certain rank to back-up information, and those memory locations, which are to be backed up or the memory locations, which are not to be backed up are either memory locations with a higher or lower rank than the determined rank.

16. The processor according to claim 15, wherein the command processing means (16) is adapted to store the intermediate results of those memory locations during back-up, which have a higher rank than the determined rank, and to not store the intermediate results of those memory locations which have a lower rank than the determined rank, or, on the contrary, do not store the intermediate results of those memory locations, which have a higher rank than the determined rank, and to store intermediate results of those memory locations, which have a lower rank than the determined rank.

17. The processor according to one of claims 1 to 13 or 15, comprising:
a log unit for setting a mark for every memory location (22), to which an intermediate value has been stored during the processing of the mother program,
wherein the command processing means (16) is adapted to back up the intermediate results of those memory locations during back up for which a mark is set, minus the intermediate result of those memory locations which are indicated by the back-up information.

18. The processor according to claim 17, where the command processing means is adapted to enter, during the entering of the data, together with the data, back-up information in the stack memory.

19. A method for processing a program with commands comprising a mother program with a sub-program jump command and a sub-program, which is to be executed in response to the sub-program jump command, comprising:
upon occurrence of the sub-program jump command in a mother program, by a command decoder,
extracting, from the sub-program jump command, back-up information about data required in the mother program after processing the sub-program;
extracting a destination address from the sub-program jump command, the destination address referring to the sub-program,
and by a command processing means,
backing-up, based on the back-up information, data required in the mother program after processing the sub-program; and
effecting, based on a destination address, the processing of the program to be continued with the sub-program.

20. A computer program with a program code for executing the method according to claim 19 when the computer program runs on a computer.

## Revendications

1. Processeur pour exécuter un programme (26) avec des commandes, présentant un programme-mère avec une commande de saut vers un sous-programme et un sous-programme qui doit être exécuté en réponse à la commande de saut vers un sous-programme, avec
un moyen de traitement de commande (16);
un décodeur de commande (18) qui est réalisé, en cas d'occurrence de la commande de saut vers un sous-programme dans le programme-mère, de manière à
extraire de la commande de saut vers un sous-programme des informations de sauvegarde sur les données requises après l'exécution du sous-programme dans le programme-mère;
extraire de la commande de saut vers un sous-programme une adresse cible qui renvoie au sous-programme; et
communiquer au moyen de traitement de commande (16) l'occurrence de la commande de saut vers un sous-programme dans le programme-mère ainsi que les informations de sauvegarde et l'adresse cible,
le moyen de traitement de commande (16) étant réalisé, en cas d'occurrence de la commande de saut vers un sous-programme dans le programme-mère, de manière à
sauvegarder sur base des informations de sauvegarde, les données requises après l'exécution du sous-programme dans le programme-mère; et
provoquer, sur base de l'adresse cible, que l'exécution du programme soit continué par le sous-programme.

2. Processeur selon la revendication 1, dans lequel le processeur présente un ensemble de commandes (24) composé de plusieurs opérations de commande pouvant être identifiées de manière univoque par des codes d'opération, parmi les opérations de commande se trouvant une opération de commande de saut vers un sous-programme qui est identifiée de manière univoque par un code d'opération de commande de saut vers un sous-programme, et dans lequel chaque commande du programme présente un code d'opération par lequel cette dernière peut être associée à l'une des opérations de commande, le décodeur de commande (18) étant réalisé de manière à décoder une commande du programme-mère actuellement à exécuter, pour obtenir le code d'opération de celle-ci, et à communiquer l'occurrence de la commande de saut vers un sous-programme au moyen de traitement de commande (16) si le code d'opération de celle-ci est identique au code d'opération de commande de saut vers un sous-programme, et la commande de saut vers un sous-programme présentant, comme opérandes, l'adresse cible et les informations de sauvegarde.

3. Processeur selon la revendication 2, dans lequel est chaque fois définie, parmi les commandes du programme-mère et du sous-programme, une séquence d'exécution par laquelle le processeur est réalisé de manière à effectuer l'exécution du programme, chaque commande présentant exactement un code d'opération par lequel elle peut être associée à l'une des opérations de commande.

4. Processeur selon la revendication 3, dans lequel le processeur est réalisé de manière à exécuter chaque commande du programme dans l'un de cycles de commande successifs, le décodeur de commande (18) et le moyen de traitement de commande (16) étant réalisés de manière à effectuer l'extraction, la sauvegarde et le provocation en un seul cycle de commande.

5. Processeur selon l'une des revendications 1 à 4, présentant, par ailleurs, la caractéristique suivante:
des emplacements de mémoire (22) destinés à mémoriser des résultats intermédiaires de processeur pendant l'exécution du programme, les données requises après l'exécution du sous-programme dans le programme-mère se composant des résultats intermédiaires de processeur d'une sélection d'emplacements de mémoire, la sélection étant fonction des informations de sauvegarde.

6. Processeur selon la revendication 5, dans lequel les informations de sauvegarde indiquent au moins un emplacement de mémoire (22) appartenant à la sélection, aucun autre emplacement de mémoire n'appartenant à la sélection.

7. Processeur selon la revendication 5, dans lequel les informations de sauvegarde indiquent au moins un emplacement de mémoire (22) n'appartenant pas à la sélection.

8. Processeur selon la revendication 7, dans lequel les autres emplacements de mémoire appartiennent à la sélection.

9. Processeur selon la revendication 7, dans lequel la sélection est, en outre, fonction d'informations d'utilisation qui indiquent celui parmi les emplacements de mémoire qui a été utilisé, pendant l'exécution du programme-mère jusqu'à l'occurrence de la commande de saut vers un sous-programme, pour la mémorisation de résultats intermédiaires, de sorte que la sélection comprenne les emplacements de mémoire qui sont indiqués par les informations d'utilisation comme étant utilisés pendant l'exécution du programme-mère jusqu'à l'occurrence de la commande de saut vers un sous-programme et qui, en même temps, n'appartiennent pas aux emplacements de mémoire qui sont indiqués par les informations de sauvegarde.

10. Processeur selon l'une des revendications 1 à 9, dans lequel le moyen de traitement de commande (16) est réalisé de manière à entrer, lors de la sauvegarde des données requises après l'exécution du sous-programme dans le programme-mère, les données dans une mémoire à colonne (14).

11. Processeur selon la revendication 10, dans lequel le moyen de traitement de commande (16) est réalisé de manière à entreposer, lors de l'entreposage des données dans la mémoire à colonne (14), ensemble avec les données également les informations de sauvegarde.

12. Processeur selon l'une des revendications 2 à 11, dans lequel le sous-programme présente une commande de saut en arrière et dans lequel l'ensemble de commandes (24) présente, par ailleurs, une opération de commande de saut en arrière qui peut être identifiée par un code d'opération de commande de saut en arrière univoque, le décodeur de commande (18) étant réalisé de manière à communiquer au moyen de traitement de commande (16), au cas où le code d'opération de la commande actuellement à exécuter coïncide avec le code d'opération de commande de saut en arrière, l'occurrence de la commande de saut en arrière, le moyen de traitement de commande (16) étant réalisé de manière à rétablir, à l'occurrence de la commande de saut en arrière, les données sauvegardées sur base des informations de sauvegarde mémorisées.

13. Processeur selon l'une des revendications 1 à 12, dans lequel les informations de sauvegarde comprennent un mot binaire présentant une pluralité de bits qui sont attribués, chacun, à l'un des emplacements de mémoire (22), tous les bits qui sont attribués à des emplacements de mémoire devant être mémorisés, ou tous les bits qui sont attribués à des emplacements de mémoire ne devant pas être mémorisés, présentant un premier état logique, tandis que les autres bits présentent un deuxième état logique opposé aux premiers bits.

14. Processeur selon la revendication 14, dans lequel le moyen de traitement de commande (16) est réalisé de manière à sauvegarder, lors de la sauvegarde, les résultats intermédiaires des emplacements de mémoire qui sont associés à des bits présentant le premier état logique, et à ne pas sauvegarder les résultats intermédiaires des emplacements de mémoire qui sont associés à des bits présentant le deuxième état logique ou, inversement, à ne pas sauvegarder les résultats intermédiaires des emplacements de mémoire qui sont associés à des bits présentant le premier état logique, et à sauvegarder les résultats intermédiaires des emplacements de mémoire qui sont associés à des bits présentant le deuxième état logique.

15. Processeur selon l'une des revendications 5 à 12, dans lequel est défini parmi les emplacements de mémoire (22) un ordre de rang, les informations de sauvegarde indiquent un emplacement de mémoire d'un rang déterminé, et les emplacements de mémoire qui doivent être sauvegardés ou les emplacements de mémoire qui ne doivent pas être sauvegardés sont les emplacements de mémoire soit d'un rang supérieur, soit d'un rang inférieur au rang déterminé.

16. Processeur selon la revendication 15, dans lequel le moyen de traitement de commande (16) est réalisé de manière à mémoriser, lors de la sauvegarde, les résultats intermédiaires des emplacements de mémoire qui sont d'un rang supérieur au rang déterminé, et à ne pas mémoriser les résultats intermédiaires des emplacements de mémoire qui sont d'un rang inférieur au rang déterminé, ou, inversement, à ne pas mémoriser les résultats intermédiaires des emplacements de mémoire qui sont d'un rang supérieur au rang déterminé, et à mémoriser les résultats intermédiaires des emplacements de mémoire qui sont d'un rang inférieur au rang déterminé.

17. Processeur selon l'une des revendications 1 à 13 ou 15, présentant la caractéristique suivante:
un moyen de protocolisation destiné à placer un repère pour chaque emplacement de mémoire (22), dans lequel une valeur intermédiaire a été mémorisée pendant l'exécution du programme-mère,
le moyen de traitement de commande (16) est réalisé de manière à sauvegarder, lors de la sauvegarde, les résultats intermédiaires des emplacements de mémoire pour lesquels est placé un repère, sous déduction des résultats intermédiaires des emplacements de mémoire qui sont indiqués par les informations de sauvegarde.

18. Processeur selon la revendication 17, dans lequel le moyen de traitement de commande est réalisé de manière à entreposer, lors de l'entreposage des données dans la mémoire à colonne, ensemble avec les données également les informations de sauvegarde.

19. Procédé pour exécuter un programme avec des commandes, qui présente un programme-mère avec une commande de saut vers un sous-programme et un sous-programme devant être exécuté en réponse à la commande de saut vers un sous-programme, le procédé présentant les étapes suivantes consistant à:
à l'occurrence de la commande de saut vers un sous-programme dans le programme-mère, par un décodeur de commande,
extraire de la commande de saut vers un sous-programme les informations de sauvegarde sur les données requises après l'exécution du sous-programme dans le programme-mère; et
extraire une adresse cible de la commande de saut vers un sous-programme, l'adresse cible renvoyant au sous-programme, et par un moyen de traitement de commande,
sauvegarder les données requises après l'exécution du sous-programme dans le programme-mère sur base des informations de sauvegarde; et
provoquer, sur base de l'adresse cible, que l'exécution du programme soit continué par le sous-programme.

20. Programme d'ordinateur avec un code de programme pour exécuter le procédé selon la revendication 19 lorsque le programme d'ordinateur est exécuté sur un ordinateur.
